# EUROPÄISCHE PATENTSCHRIFT

(11) **EP 1 366 313 B1**
(45) Veröffentlichungstag und Bekanntmachung des Hinweises auf die Patenterteilung: **15.09.2004**
(21) Anmeldenummer: 02708237.9
(22) Anmeldetag: 12.02.2002
(51) Int. Cl.: F16H 61/00

(54) **MECHATRONISCHE GETRIEBESTEUERUNG**
MECHATRONIC TRANSMISSION CONTROL
COMMANDE DE TRANSMISSION MECATRONIQUE

(30) Priorität: 07.03.2001 DE 10110948
(43) Veröffentlichungstag der Anmeldung: 03.12.2003
(73) Patentinhaber: SIEMENS AKTIENGESELLSCHAFT, 80333 München (DE)
(72) Erfinder: JUNGBAUER, Bernd, 93051 Regensburg (DE); MENTZEL, Georg, 93053 Regensburg (DE); LINCKE, Christoph, 93047 Regensburg (DE); LOIBL, Josef, 93077 Bad Abbach (DE)
(86) Internationale Anmeldenummer: PCT/DE2002/000505
(87) Internationale Veröffentlichungsnummer: WO 2002/070921

(56) Entgegenhaltungen:
- DE-A- 19 821 897
- DE-C- 19 751 095

## Beschreibung

Die Erfindung betrifft eine mechatronische Getriebesteuerung mit den im Oberbegriff des Anspruches 1 angegebenen Merkmalen.

Zum Hintergrund der Erfindung ist festzuhalten, daß aus Kosten- und Qualitätsgründen sogenannte Stand-alone-Getriebeelektroniken für Automatikgetriebe bei modernen Entwicklungen direkt in das eigentliche Getriebe integriert werden. Die so entstandene Einheit aus mechanischen Komponenten, wie z. B. Kunststoff-Tragekörper inklusive der darauf befindlichen Aktoren, hydraulische Komponenten und die notwendigen elektromechanischen Verbindungselemente, ferner aus Sensorkomponenten, die Drehzahl-, Druck-, Temperatur-, Wegesensoren u. dgl. bilden, und aus Elektronikkomponenten, die die eigentliche elektronische Steuereinheit in der Regel auf Basis eines Keramiksubstrates bilden, wird im Fachjargon als mechatronische Getriebesteuerung bezeichnet.

Konventionelle Stand-alone-Getriebeelektroniken befinden sich nun üblicherweise im Motor- oder Fahrzeuginnenraum. Die dabei eingesetzten Sensoren sind in ein gesondertes Gehäuse integriert, das am eigentlichen Getriebe positioniert wird. Mittels eines Kabels und einer Steckverbindung wird die elektrische Verbindung zwischen Sensorik und Getriebeelektronik hergestellt.

Problematisch ist dabei die Zuverlässigkeit der elektrischen Verbindung zwischen der elektronischen Steuereinheit und deren Sensorkomponenten. Es muß gewährleistet sein, daß die Sensorkomponenten inklusive eventuell vorhandener Elektronikbauteile z. B. für die Signalaufbereitung vor Umwelteinflüssen geschützt ist. Solche Einflüsse stellen beispielsweise mechanische Beanspruchungen, wie Motorvibrationen oder thermische Einflüsse und Umgebungsmedien, wie Staub, Wasser oder Öl dar. Dabei sind Bauraumgegebenheiten, wie sie im Getriebe vorherrschen, ebenfalls zu berücksichtigen, was oftmals die Problematik der Zuverlässigkeit verschärft.

Bei dem geschilderten Stand der Technik, bei der die elektrische Verbindung des Sensorelementes zur elektronischen Steuereinheit über entsprechende Stecker und Kabel oder sogenannte Stanzgitter erfolgt, die mit dem Anschlußkontakt der jeweiligen elektronischen Sensorkomponente bzw. dem Stecker verlötet werden, ist es bekannt, alle genannten Bauteile zum Schutz vor Umwelteinflüssen mittels einer Vergußmasse in das Gehäuse einzugießen. Der dichte Verguß eines Verbindungskabel oder eventuell vorhandenem Stanzgitters ist hierbei technisch nicht unproblematisch.

Weitere Nachteile der Anschlußtechnik nach dem Stand der Technik liegen darin, daß die Komplettanordnung des Sensors mit Gehäuse, Kabel und entsprechenden Steckverbindungen einen hohen Platzbedarf mit sich bringt. Ferner werden die Steckverbindungen üblicherweise mit Dichtungen versehen, um die elektrischen Kontakte vor Umwelteinflüssen, wie Temperaturbeanspruchung, Verschmutzung und aggressive Medien zu schützen. Zur Sicherung der mechanisch festen Verbindung sind ferner in der Regel Schnappverbindungen oder Metallbügel im Bereich des Steckers vorgesehen.

Zusammenfassend werden im Stand der Technik - bedingt durch die erörterten Anforderungen - mechanisch aufwendige und damit kostenintensive Konstruktionen für die Anbindung der Sensorik an die eigentliche elektronische Steuereinheit von mechatronischen Getriebesteuerungen eingesetzt.

Die Schrift DE-A-19821897 zeigt hierbei die Merkmale des Oberbegriffs des unabhängigen Anspruchs 1.

Davon ausgehend liegt der Erfindung die Aufgabe zugrunde, eine mechatronische Getriebesteuerung so auszugestalten, daß auf einfachere Weise eine zuverlässige Verbindung zwischen Sensorik und elektronischer Steuereinheit der Getriebesteuerung erzielbar ist.

Diese Aufgabe wird laut Kennzeichnungsteil des Anspruches 1 dadurch gelöst, daß als elektrisches und mechanisches Verbindungselement zwischen den Sensorkomponenten und der elektronischen Steuereinheit eine flexible Leiterplatte fungiert, auf der die Sensorkomponenten plaziert sind.

Durch diesen Kerngedanken der Erfindung ist es möglich, eine sehr zuverlässige, einfache und flexible Verbindung zwischen den Sensorkomponenten und der elektronischen Steuereinheit zu schaffen. Da die elektronischen Sensorkomponenten direkt auf die Leiterbahnen der flexiblen Leiterplatte aufgelötet werden können, können sämtliche Steckverbindungen, wie sie beim Stand der Technik vorgesehen und notwendig sind, entfallen. Dadurch können sehr kompakte und insbesondere flache Bauformen für verschiedene Sensoren erzielt werden. Erhebliche Freiheit besteht auch bei dem Design des Sensors, der für den liegenden, stehenden oder auch schrägen Einbau konzipiert werden kann, da die flexible Leiterplatte im Prinzip beliebig biegbar ist. Dadurch kann auch der Einbauort, an dem sich das Sensorelement und die eventuell vorhandene Zusatzbeschaltung befindet, völlig frei gewählt werden. Dies hat den Vorteil, daß der Einsatzort des Getriebes an beliebig vorgebbare, mechanische Randbedingungen, wie z. B. die fixe Lage von abzutastenden Geberräder oder verschiebbaren Wellen, anzupassen.

Ferner ist die Erfindung für eine einfach realisierbare Abdichtung geschaffen. Die an sich bekannte Vergußmasse ist nämlich gerade in Zusammenarbeit mit einer flexiblen Leiterplatte zur elektrischen und mechanischen Anbindung der Sensorkomponenten problemloser und sicherer beherrschbar als beim Stand der Technik.

Weitere Merkmale, Einzelheiten und vorteilhafte Ausführungsformen der Erfindung sind der nachfolgenden Beschreibung entnehmbar, in der ein Ausführungsbeispiel anhand der beigefügten Zeichnungen näher erläutert wird. Es zeigen:
- Fig. 1: eine ausschnittsweise schematische Seitenansicht einer mechatronischen Getriebesteuerung,
- Fig. 2: eine Draufsicht auf eine flexible Leiterplatte mit Sensorkomponenten und Zusatzbeschaltung der Getriebesteuerung gemäß Fig. 1, und
- Fig. 3: eine schematische Draufsicht auf einen in der Getriebesteuerung einsetzbaren Wegesensor.

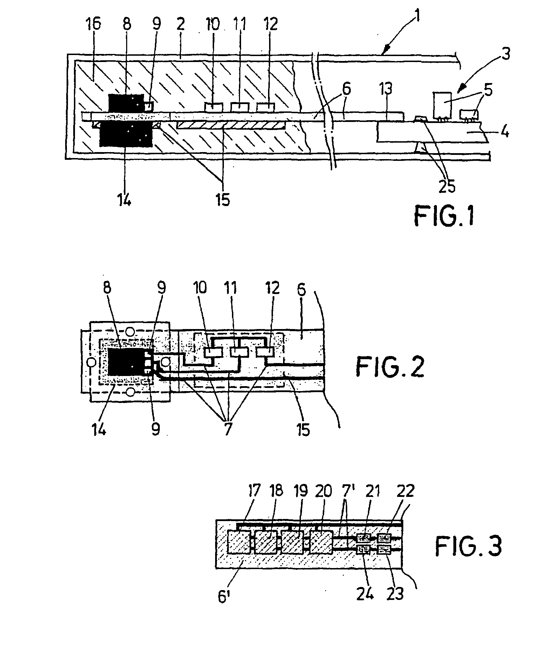

Wie aus Fig. 1 deutlich wird, ist die mechatronische Getriebesteuerung 1 in einem Gehäuse 2 untergebracht, das in nicht näher dargestellter Weise direkt an das Getriebe eines Kraftfahrzeuges angeflanscht bzw. in das Getriebe integriert wird. Kernstück der Getriebesteuerung 1 ist eine elektronische Steuereinheit 3, auf deren fester Platine 4 auf der Basis eines beispielsweise keramischen Substrates die einzelnen elektronischen Komponenten 5 in üblicher Technik, wie z. B. SMD-Technik, montiert sind. Die Platine 4 ist in schematisch dargestellter Weise durch geeignete mechanische Elemente 25 im Gehäuse 2 gelagert.

Mit der Platine 4 ist eine flexible Leiterplatte 6 in Form eines langgestreckten, in Draufsicht im wesentlichen rechteckigen Streifens verbunden. Diese flexible Leiterplatte 6 besteht beispielsweise aus einer flexiblen, jedoch haltbaren, elektrisch isolierenden Folie, auf der Leiterbahnen 7 für die elektrische Verbindung der elektronischen Komponenten 5 in der Steuereinheit 3 mit den auf der flexiblen Leiterplatte 6 angeordneten Sensorkomponenten sorgen. Bei diesen Sensorkomponenten handelt es sich um den eigentlichen, am freien Ende der Leiterplatte 6 angeordneten elektronischen Sensor-Baustein 8 in Form eines IC-Chips, dessen Anschlüsse 9 über die Leiterbahnen 7 mit weiterhin auf der Leiterplatte 6 montierten zusätzlichen Beschaltungskomponenten 10, 11, 12 in dem jeweiligen Schaltungszweck entsprechender Weise verbunden sind. Die zur Platine 4 führende Leiterbahn 7 ist an der in Fig. 1 rein schematisch dargestellten Verbindungsstelle 13 in geeigneter Weise in eine Leiterbahn auf der Platine 4 übergeführt. Die mechanische Verbindung zwischen Leiterplatte 6 und Platine 4 kann beispielsweise durch Verkleben oder Ultraschall-Schweißen erfolgen.

Auf der dem Sensor-Baustein 8 und den Beschaltungskomponenten 10, 11, 12 abgewandten Unterseite der Leiterplatte 6 ist ferner als passives Hilfselement ein Magnet 14 durch Kleben befestigt, der bei Auslegung des Sensors beispielsweise als Hall-Drehzahlsensor notwendig ist.

An der Unterseite der Leiterplatte 6 ist ferner unter den Beschaltungskomponenten 10, 11, 12 ein plattenförmiges Unterstützungsteil 15 angeklebt, das die Leiterplatte 6 in diesem Bereich unflexibel macht. Damit wird einem Abbrechen der angelöteten Beschaltungskomponenten 10, 11, 12 von der Leiterplatte 6 vorgebeugt.

Schließlich ist die Leiterplatte 6 im Bereich ihres der Platine 4 abgewandten Ende unter Einschluß der Beschaltungskomponenten 10, 11, 12, des Sensor-Bausteins 8 und des Magneten 14 im Gehäuse 2 komplett durch eine Vergußmasse 16 eingebettet, so daß diese Komponenten hermetisch gegen Umwelteinflüsse abgedichtet sind. Durch diese zusätzliche Dichtfunktion kann die gesamte Anordnung auch direkt im Getriebeöl eingetaucht positioniert werden.

Sensor-Baustein 8 und Beschaltungskomponenten 10, 11, 12 können durch übliche SMD-Lötprozesse auf der flexiblen Leiterplatte 6 befestigt werden. Bei entsprechender Verfügbarkeit als sogenannte "bare dies" können solche Bausteine auch direkt auf die Leiterbahnen 7 der flexiblen Leiterplatte 6 gebondet werden.

Um die universelle Anwendbarkeit der erfindungsgemäßen Konstruktion nahezubringen, zeigt Fig. 3 eine Auslegung der Sensorkomponenten in Form von vier linear hintereinander geschalteten Wegesensoren 17, 18, 19, 20, denen wieder entsprechende zusätzliche Beschaltungskomponenten 21, 22, 23, 24 zur Signalaufbereitung zugeordnet sind. Die elektrische Verbindung erfolgt wiederum über schematisch dargestellte, auf der flexiblen Leiterplatte 6' aufgebrachte Leiterbahnen 7'.

## Patentansprüche

1. Mechatronische Getriebesteuerung umfassend
- ein an ein Kfz-Getriebe anbaubares Gehäuse (2),
- eine elektronische Steuereinheit (3), deren Komponenten (5) auf einer festen Platine (4) im Gehäuse (2) angeordnet sind,
- Mechanikkomponenten (25), und
- Sensorkomponenten (8, 10, 11, 12, 14, 17 bis 24), die mit der elektronischen Steuereinheit (3) gekoppelt sind,
**gekennzeichnet durch**
- eine flexible Leiterplatte (6), auf der die Sensorkomponenten (8, 10, 11, 12, 14, 17 bis 24) plaziert sind und die als elektrisches und mechanisches Verbindungselement zwischen den Sensorkomponenten (8, 10, 11, 12, 14, 17 bis 24) und der elektronischen Steuereinheit (3) fungiert.

2. Getriebesteuerung nach Anspruch 1, **dadurch gekennzeichnet, daß** die flexible Leiterplatte (6) mit den Sensorkomponenten (8, 10, 11, 12, 14, 17 bis 24) in eine Vergußmasse (16) eingebettet ist.

3. Getriebesteuerung nach Anspruch 1 oder 2, **dadurch gekennzeichnet, daß** als Sensorkomponenten die eigentlichen Sensoren (8, 17, 18, 19, 20), passive Hilfselemente (14) und Zusatzbeschaltungskomponenten (10, 11, 12, 21, 22, 23, 24) auf der flexiblen Leiterplatte (6) angeordnet sind.

4. Getriebesteuerung nach einem der Ansprüche 1 bis 3, **dadurch gekennzeichnet, daß** auf der den Sensorkomponenten (8, 10, 11, 12, 14, 17 bis 24) abgewandten Seite der flexiblen Leiterplatte (6) ein mechanisches Unterstützungsteil (15) aufgebracht ist.

5. Getriebesteuerung nach einem der Ansprüche 1 bis 4, **dadurch gekennzeichnet, daß** die elektronischen Sensorkomponenten (8, 10, 11, 12, 14, 17 bis 24) mit den Leiterbahnen (7, 7') der flexiblen Leiterplatte (6) mittels eines SMD-Lötprozesses oder Bondens elektrisch und mechanisch verbindbar sind.

6. Getriebesteuerung nach einem der Ansprüche 1 bis 5, **dadurch gekennzeichnet, daß** passive Hilfselemente (14) der Sensorkomponenten (8, 10, 11, 12, 17 bis 24) auf die flexible Leiterplatte (6) aufgeklebt sind.

## Claims

1. Mechatronic transmission control comprising
- a housing attachable to a motor vehicle transmission (2),
- an electronic control unit (3) for which the components (5) are arranged on a rigid circuit board (4) in the housing (2),
- Mechanical components (25), and
- Sensor components (8, 10, 11, 12, 14, 17 to 24) which are coupled to the electronic control unit (3),
**characterized by**
- a flexible printed circuit board (6), on which the sensor components (8, 10, 11, 12, 14, 17 to 24) are placed and which functions as an electrical and mechanical connecting element between the sensor components (8, 10, 11, 12, 14, 17 to 24) and the electronic control unit (3).

2. Transmission in accordance with claim 1, **characterized in that** the flexible printed circuit board (6) is embedded with the sensor components (8, 10, 11, 12, 14, 17 to 24) in a molded body (16).

3. Transmission in accordance with Claim 1 or 2, **characterized in that** the actual sensors (8, 17, 18, 19, 20), passive auxiliary elements (14) and additional circuit components (10, 11, 12, 21, 22, 23, 24) are arranged as sensor components on the flexible printed circuit board (6).

4. Transmission in accordance with one of the Claims 1 to 3, **characterized in that** a mechanical support section (15) is fitted to the opposite side of the flexible printed circuit board (6) from the sensor components (8, 10, 11, 12, 14, 17 to 24).

5. Transmission in accordance with one of the Claims 1 to 4, **characterized in that** the electronic sensor components (8, 10, 11, 12, 14, 17 to 24) can be connected electrically or mechanically to the conductor tracks (7, 7') of the flexible circuit board(6) using an SMD soldering process or bonding.

6. Transmission in accordance with one of the Claims 1 to 5, **characterized in that** passive auxiliary elements (14) of the sensor components (8, 10, 11, 12, 17 to 24) are glued to the printed circuit board (6).

## Revendications

1. Commande de boîte de vitesses mécatronique comportant :
- un boîtier (2) qui peut être monté sur une boîte de vitesses de véhicule à moteur,
- une unité de commande électronique (3), dont les composants (5) sont montés sur une platine fixe (4) dans le boîtier (2),
- des composants mécaniques (25), et
- des composants de capteurs (8, 10, 11, 12, 14, 17 à 24), qui sont couplés avec l'unité de commande électronique (3),
**caractérisée par**
- une carte imprimée souple (6) sur laquelle sont placés les composants de capteurs (8, 10, 11, 12, 14, 17 à 24) et qui sert d'élément de liaison électrique et mécanique entre les composants de capteurs (8, 10, 11, 12, 14, 17 à 24) et l'unité de commande électronique (3).

2. Commande de boîte de vitesses selon la revendication 1, **caractérisée en ce que** le carte imprimée souple (6) est noyée dans une masse de remplissage (16) avec les composants de capteurs (8, 10, 11, 12, 14, 17 à 24).

3. Commande de boîte de vitesses selon la revendication 1 ou 2, **caractérisée en ce que**, comme composants de capteurs, les capteurs proprement dits (8, 17, 18, 19, 20), les éléments auxiliaires passifs (14) et les composants de connexion additionnelle (10, 11, 12, 21, 22, 23, 24) sont montés sur la carte imprimée souple (6).

4. Commande de boîte de vitesses selon l'une des revendications 1 à 3, **caractérisée en ce qu'**une pièce de support mécanique (15) est placée sur le côté de la carte imprimée souple (6) opposé aux composants de capteurs (8, 10, 11, 12, 14, 17 à 24).

5. Commande de boîte de vitesses selon l'une des revendications 1 à 4, **caractérisée en ce que** les composants de capteurs électroniques (8, 10 11, 12, 14, 17 à 24) peuvent être reliés électriquement et mécaniquement aux pistes conductrices (7, 7') de la carte imprimée souple (6) au moyen d'un procédé de brasage SMD ou par métallisation.

6. Commande de boîte de vitesses selon l'une des revendications 1 à 5, **caractérisée en ce que** des éléments auxiliaires passifs (14) des composants de capteurs électroniques (8, 10 11, 12, 17 à 24) sont collés sur la carte imprimée souple (6).
